## Europäisches Patentamt
## European Patent Office
## Office européen des brevets

(11) Publication number: **0 048 152**
**B1**

(12) **EUROPEAN PATENT SPECIFICATION**

(45) Date of publication of patent specification: **06.02.85**

(21) Application number: **81304193.6**

(22) Date of filing: **14.09.81**

(51) Int. Cl.⁴: **G 11 B 5/09**

(54) **A PCM signal processor.**

(30) Priority: **16.09.80 JP 128331/80**

(43) Date of publication of application:
**24.03.82 Bulletin 82/12**

(45) Publication of the grant of the patent:
**06.02.85 Bulletin 85/06**

(84) Designated Contracting States:
**DE FR GB IT NL**

(56) References cited:

**JOURNAL OF AUDIO ENGINEERING SOCIETY, vol. 28, 1980, April, no. 4, New York, US Technical Committee Reports: "Consumer Use PCM Encoder-Decoder 1979-6"; Electronic Industries Association of Japan Technical File of the Stereo Technical Committee and the Video Technical Committee STC-007, pages 260-265**

(73) Proprietor: **Kabushiki Kaisha Toshiba
72, Horikawa-cho Saiwai-ku
Kawasaki-shi Kanagawa-ken 210 (JP)**

(72) Inventor: **Kojima, Tadashi c/o Patent Division
Tokyo Shibaura Denki K.K. 72, Horikawa-cho
Saiwai-ku Kawasaki-shi Kanagawa-ken, 210 (JP)**

(74) Representative: **Newstead, Michael John
Haseltine Lake & Co. 28 Southampton Buildings
Chancery Lane
London, WC2A 1AT (GB)**

Courier Press, Leamington Spa, England.

# Description

The present invention relates to a PCM (pulse code modulation) signal processor.

As prior art there can be mentioned British Patent Specification No. 2,019,168.

In the field of audio engineering, digital technology has been utilised mostly in professional equipment design. A proliferation of consumer video cassette tape recorders has, however, recently led to the use of digital technology in consumer audio equipment.

A pulse code modulation (PCM) recording and playback system made possible by combining a video tape recorder (VTR) and digital technology has a strikingly broader dynamic range with practically no wow and flutter compared with current analogue tape recorders. Their frequency and distortion characteristics are also much superior to current systems. Having all of these various advantages, the applications of digital technology in the audio engineering field are considered to be most effective.

However, unlike for current analogue systems, a PCM audio system using VTRs requires a digital signal processor for signal transformation to or from a TV signal of a standard system, such as the NTSC system, according to suitable signal format, on recording or reproducing the PCM signal.

As the PCM audio signal format, there may be used the format prescribed by the EIAJ (Electronic Industries Association of Japan) Technical File: STC-007, which employs bit error correction schemes together with interleaving techniques, as described in detail later.

Furthermore, in encoding of the PCM audio signals in the TV signal, various control signals as well as the PCM audio signals are also inserted into the TV signal. The control signals are used for controlling decoders to suitable conditions, as described in detail later.

However, conventional PCM signal processors for decoding the encoded PCM audio signals are insufficient for an error correction of the control signals, compared to the error correction of the PCM audio signals.

It is an object of the present invention to provide a PCM signal processor controlled well by control signals.

According to the present invention, there is provided a PCM signal processor for decoding PCM signals from a TV format signal whose vertical period includes firstly a control data block comprising a control data word for use in the control of a decoding operation and an error detection and correction word and secondly a data block comprising PCM data words, the said processor comprising means for demodulating the said control data block and the said data block from the said TV format signal input to it, means for converting the said blocks to parallel signals respectively, means for de-interleaving the said parallel signals of the said data block, means for processing the said de-interleaved signals, and means connected to the said converting means and responsive to the said error detection and correction word for forming an error pointer signal having a first state indicating the presence of an error in the said control data block and a second state indicating the absence of an error in the said control data block, characterised in that the processor further comprises:

means for latching the said control data word outputted from the said converting means when the said error pointer signal is in the said second state and for preventing the latching of the said control data word when the said error pointer signal is in the said first state;

means for checking agreement between the said control data word outputted from the said converting means and the said latched control data word in the said latching means; and

means for applying the said latched control data word which is checked as regards agreement with the said outputted control data word to the said processing means so as to control the processing of the said de-interleaved PCM data words.

The present invention will now be described, by way of example, with reference to the accompanying drawings, in which:—

Figure 1 shows one type of word signal allocation for a horizontal line period of a TV signal according to the EIAJ format;

Figure 2 shows a control signal allocation for a horizontal line period;

Figure 3 shows another type of word signal allocation;

Figure 4A shows a signal allocation for an even vertical field period;

Figure 4B shows a signal allocation for an odd vertical field period; and

Figure 5 is a block diagram of one embodiment of a PCM signal processor according to the present invention.

Throughout the drawings, the same reference letters and numerals will be used to designate like or equivalent elements.

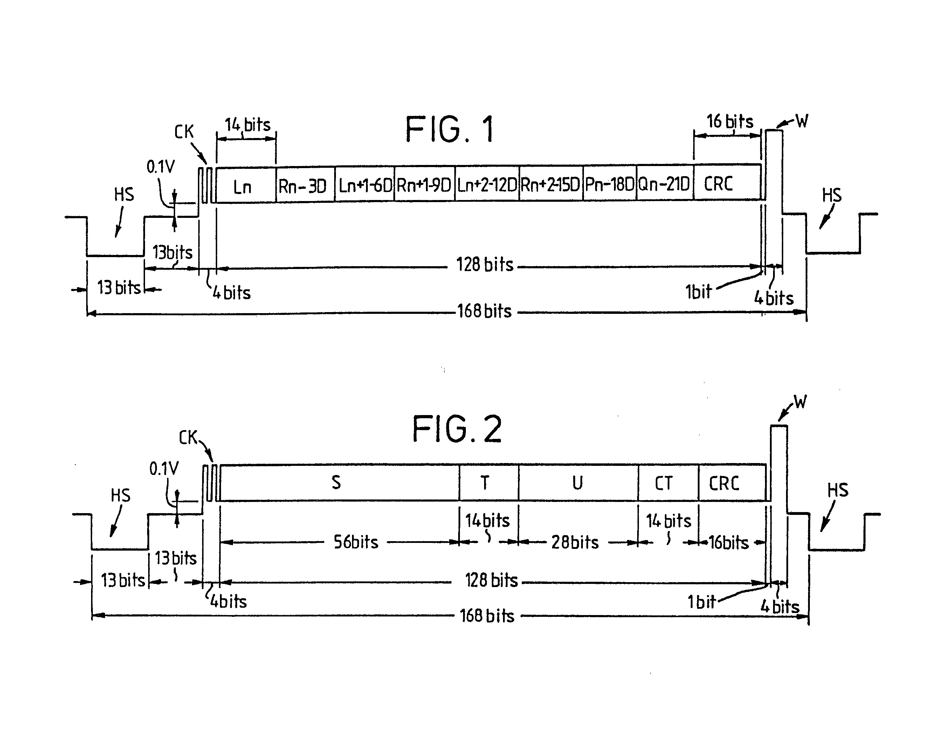

First, there will be described the EIAJ signal format referring to Figures 1 to 4B.

On PCM encoding of analogue audio signals, by way of example two channel stereophonic (L and R) analogue signals, the signals are individually sampled at a sampling frequency of about 44 kHz. Each piece of sampled data (i.e. one word) is transformed into a PCM data word of 14-bits or 16-bits and then allocated in a video signal portion of a standard television (TV) signal. Figure 1 shows an example of a waveform or data format of one horizontal scanning period (1H period) for the case where one word is of the 14-bit data form mentioned above. Three words are included per channel, and in total, six words Ln, Rn—3D, Ln+1—6D, Rn+1—9D, Ln+2—12D and Rn+2—15D are put in a video signal block in one horizontal line, with two check words P and Q for error correction and with one word CRC for error detection, all of which constitute a 9-word, 128-bit data block.

Word CRC consists of 16 bits, but all other words are 14 bits. The PCM data L and R according to Figure 1 respectively correspond to the left and right sampled data, and suffixes $n$ represent the sampling order. In the format of Figure 1, the data is interleaved such that, in each sampled data, the six words and two check words P and Q, i.e. a total of eight words, are successively shifted by 16 blocks (i.e. 16 horizontal lines) for each word, and D in the aforementioned suffixes represents this number of blocks (D=16) of the interleave. In this case, the interleave of D=16 blocks is equivalent to a word-interleave of 3D=48 words.

In Figure 1, the period of one horizontal line (1H) is constituted by 168 bits. In this 168-bit interval, the horizontal synchronising signal HS which has 13 bits is placed, then a 4-bit clock signal CK for synchronization of data is placed after an interval of 13 bits, and then the aforementioned 128-bit data block is placed. The code of the data synchronization signal CK is, for instance, "1010". Also, after the 128-bit data block a "0" signal of one bit is placed, and then a white reference signal W with a pulse width of 4 bits is placed.

Figure 2 shows a 1H period in which a control signal data block is contained. This format is the same as that of Figure 1 except for the 128-bit control data block, including the horizontal synchronising signal HS and white reference signal W. The 128-bit control data block in this case is constituted by a 56-bit heading signal word S, a 14-bit content discrimination signal word T, a 28-bit address signal word U, a 14-bit control signal word CT and the aforementioned 16-bit error detection word CRC.

The content of the 14-bit control signal word CT is set as shown in Table 1 below.

TABLE 1

| Bit No. | Code content | Control content | Bit content |
|---|---|---|---|
| 1 to 10 | No prescription | — | 0 |
| 11 | Dubbing inhibition code | Absent | 0 |
| 12 | P correction discrimination code | Present | 0 |
| 13 | Q correction discrimination code | Present | 0 |
| 14 | Pre-emphasis discrimination code | Present | 0 |

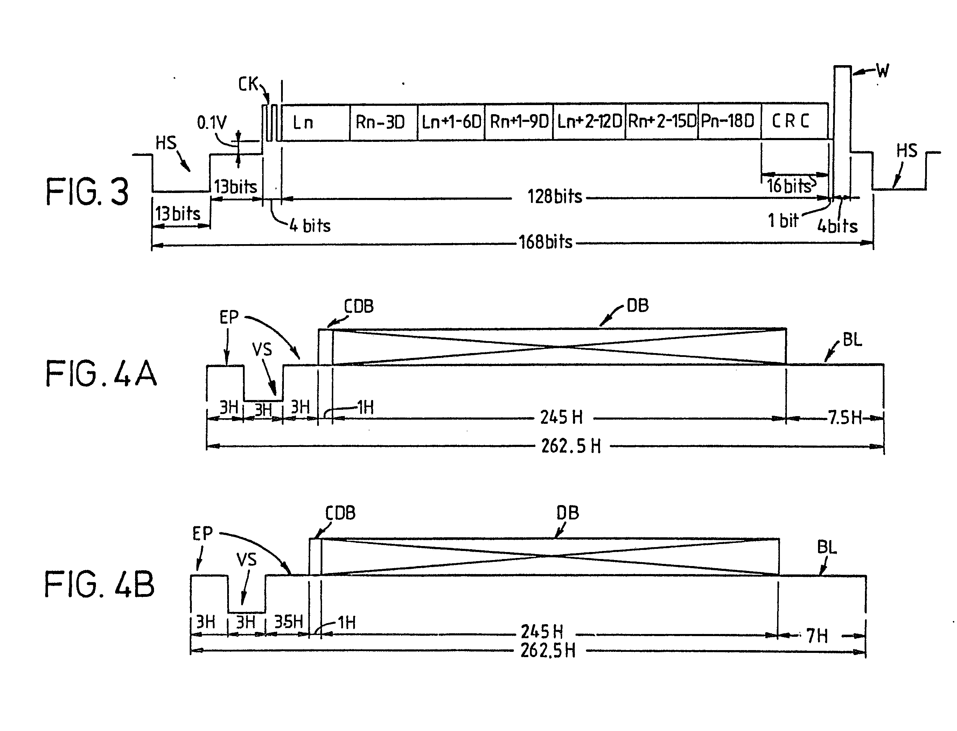

In Table 1, the Q correction discrimination code is "0" representing the "presence" for the case when the word of the PCM audio signal is constituted by 14 bits, while where one word is constituted by 16 bits, for instance as in the data format shown in Figure 3, the Q correction discrimination code is "1" representing "absence".

Figure 3 shows an example of the data block in which one word of the PCM audio signal mentioned above is constituted by 16 bits, that is, the 128-bit data block is constituted by six 16-bit words of the left and right channel audio signal data L and R, a 16-bit error correction word P and a 16-bit error detection word CRC, i.e. a total of eight words.

The above data signals for a 1H period are arranged in one vertical scanning period filed in a manner as shown, for instance, in Figures 4A and 4B. Figure 4A corresponds to an odd field, and Figure 4B corresponds to an even field. At the outset of each field, an equivalent pulse EP and a vertical synchronising signal VS are arranged, a control signal block CDB is provided in the 10-th horizontal line in the odd field (see Figure 4A) and in the 10.5-th horizontal line in the even field (see Figure 4B), and then 245 horizontal lines with data block DB are provided, the remaining horizontal lines constituting a blank period BL.

Of the 262.5 horizontal lines constituting one field in Figures 4A and 4B, the 16.6 lines other than the 246 lines in which the aforementioned control signal block CDB and data block DB are provided correspond to the vertical blanking period of the standard television signal.

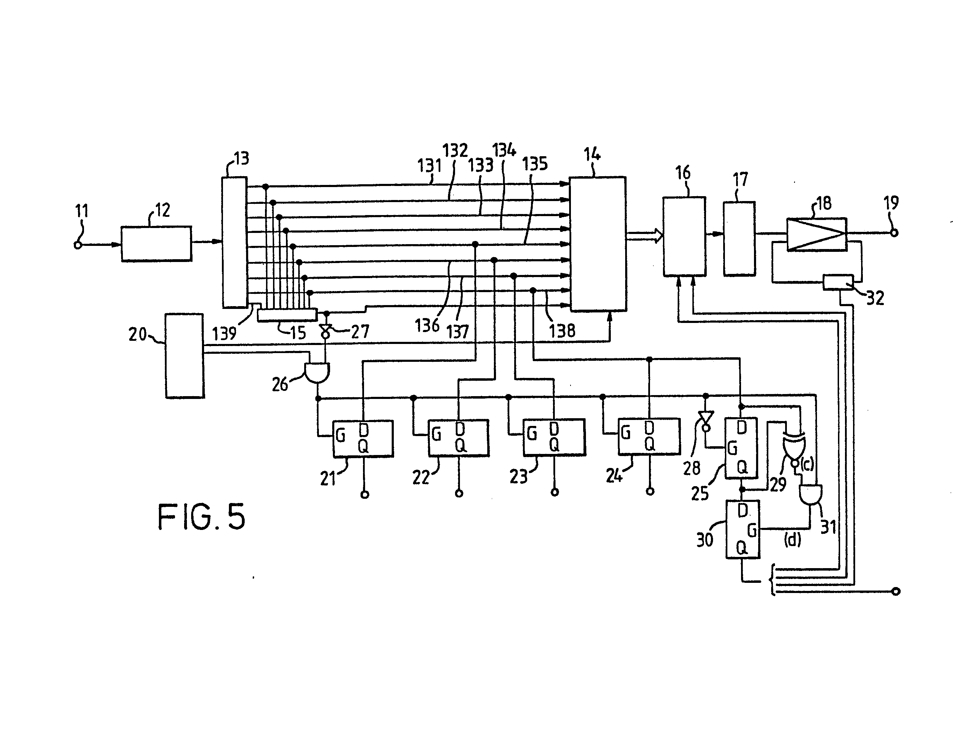

Referring to Figure 5, there is shown a block diagram of PCM audio signal decoder according to one embodiment of the present invention. Through an input terminal 11 are applied modulated PCM audio signals and the control signals reproduced from a VTR (not shown) to a TV signal demodulator 12 in which the data block including PCM data words shown in Figure 1 or Figure 2 is extracted and shaped as regards its waveforms. The data block is applied to a serial-to-parallel converter (hereinafter referred to as an S/P converter) 13 where the data block is divded into all the 14-bit words. When the data block shown in Figure 1 is applied, PCM words Ln+21D, Rn+18D, Ln+1+15D, Rn+1+12D, Ln+2+9D, Rn+2+6D, Pn+3D, Qn and CRC are outputted from nine parallel output lines 131 to 139 of S/P converter 13 respectively.

Six data words Ln+21D to Rn+2+6D and two check words Pn+3D and Qn but not check word CRC are applied to a de-interleave circuit 14 comprising delay circuits, through which seven words Ln+21D, Rn+18D, Ln+1+15D, Rn+1+12D, Ln+2+9D, Rn+2+6D and Pn+3D are delayed by different delay amounts 7D to D respectively (the meaning of D is aforementioned) but check word Qn passes in a not delayed form. Therefore, the output signals of de-interleave circuit 14 are put in the original word order, i.e. the order Ln, Rn, Ln+1, Rn+1, Ln+2, Rn+2, Pn and Qn before interleaving.

The aforementioned divided words, i.e. the six data words Ln+21D, Rn+18D, Ln+1+15D, Rn+1+12D, Ln+2+9D and Rn+2+6D and the two error correction check words Pn+3D and Qn are also applied to a block error detector 15 together with the error detection check word CRC, where an error pointer Ep for every word Ln+21D to Qn is generated under the control of check word CRC. Each error pointer Ep is also applied to the de-interleave circuit 14 where it is processed in a similar manner as the PCM words, Ln+21D to Qn. The de-interleaved PCM words are applied to an error corrector 16 where an error correction (hereinafter, the word "correction" includes the meaning of "compensation") is practiced for data words Ln, Rn, Ln+1, Rn+1, Ln+2 and Rn+2. Error corrected data words are applied to a digital-to-analogue converter (hereinafter referred as to D/A converter) 17. The analogue audio signals are amplified by an amplifier 18 and then applied to an output terminal 19.

When the control data block shown in Figure 2 is applied to S/P converter 13, 56-bit heading signal word S appears on output lines 131 to 134, divided every 14 bits. 14-bit content discrimination signal word T appears on output line 135. 28-bit address signal word U appears on output lines 136 and 137, divided every 14 bits, 14-bit control signal word CT appears on output line 138. Also, 16-bit error detection word CRC appearing on output line 139 is processed in a similar manner as CRC of the data block shown in Figure 1.

De-interleave circuit 14 is stopped as regards its operation by a pulse signal of logic value "1", from a data block detector 20, when the control data block is applied to the decoder. However, words T, U and CT outputted from S/P converter 13 are introduced to D input terminals of D-type flip-flops (hereinafter referred to as D-FFs) 21 to 25. D-FF 21 may latch word T; D-FFs 22 and 23 may latch word U in combination; D-FF 24 may latch the leading 10 bits of word CT; and D-FF25 may latch the trailing 4 bits of word CT.

Now, the error pointer for every word T, U and CT is introduced to one of the input terminals of an AND gate 26 via a NOT circuit 27. AND gate 26 is connected at its other input terminal to data block detector 20 and at its output terminal to set pulse input terminals G of D-FFs 21 to 25, directly for D-FFs 21 to 24 but via a NOT circuit 28 for D-FF 25.

Therefore, an error pointer of logic value "0" is generated from block error detector 15 if no errors are in the control data block. The logic value "0" of an error pointer is changed to logic value "1" by NOT circuit 27 and applied to the said one input of AND gate 26. Meanwhile, a pulse signal of logic value "1" is applied to the other input terminal of AND gate 26 from data block detector 20 at some time during the period in which the control data block is applied to the decoder. When the pulse signal is applied, logic value "1" appears on the output terminal of AND gate 26. The logic value "1" outputted from AND gate 26 causes D-FFs 21 to 24 latch their input signals on the D input terminals, so that words T, U and the leading 10 bits of CT appear on output terminals Q of D-FFs 21 to 24.

When there are any errors in the control data block, an error pointer of logic value "1" is produced from block error detector 15, and a logic value "0" is applied to the said one input of AND gate 26. Therefore, the output logic value of AND gate 26 becomes "0", and D-FFs 21 to 24 fail to latch words T, U and the leading 10 bits of CT on their respective D input terminals. During this period D-FFs 21 to 24 output their prior latching words. Therefore, the outputting of words T, U and the 10 bits of CT are controlled by block error detector 15.

D-FF 25 receives an inverted signal from the output of AND-gate 26 on its set pulse input terminal G, because of NOT circuit. D-FF 25 is further connected at its Q output terminal to one input terminal of an exclusive-NOR gate (hereinafter referred as to an EX-NOR gate) 29 and the D input terminal of D-FF 30. EX-NOR gate 29 is connected at its other input terminal to the D input terminal of D-FF 25 and at its output terminal to one input terminal of an AND gate 31. AND gate 31 is connected at its other input terminal to the output terminal of AND gate 26 and at its output terminal to the G input terminal of D-FF 30. D-FFs 25 and 30, EX-NOR gate 29 and AND gate 31 are illustrated by only one unit each, but in practice comprise four units respectively. The first Q output terminals of D-FF 30 may output the copy inhibition code listed in Table 1. The second and third Q output terminals of D-FF 30 may output the P and Q correction discrimination codes respectively, and are connected to control terminals of error corrector 16. The fourth Q output terminal of D-FF 30 may output the pre-emphasis discimination code, and is connected to a de-emphasis circuit 32 added to amplifier 18.

D-FF 25 fails to latch the trailing four bits of CT on its D input terminal and keeps its present latching data when the output logic value of AND gate 26 is "1", that is if no error is present while the pulse of logic value "1" is being applied to the other input of AND gate 26. However, when the pulse terminates, the input to the said other input of AND gate 26 falls to "0", causing a step from "1" to "0" in the output of AND gate 26, and thus a step from "0" to "1" on the G input of D-FF 25. Thus, the flip-flop D-FF 25 which latches data on the leading edge of a step signal, latches the trailing four bits of CT, which has been indicated as being error free. In EX-NOR gate 29, its output is logic value "1" when both its input signals agree with each other. That is, EX-NOR gate 29 outputs logic value "0" when the input and output signals of D-FF 25 disagree with each other. In this period D-FF 30 fails to latch the output of D-FF 25 because the G input of D-FF 30 is logic value "0" in spite of the output of AND gate 26. Therefore, D-FF 30 outputs its present latching data during new signals on its D input terminal and old signals or present latching signals on the Q output terminal of D-FF 25 disagreeing with each other. This means that decoders are controlled by old control data signals if new control data signals disagree with old control data signals in one prior field of the TV signal.

EX-NOR gate 29, however, outputs logic value "1" when the input data and output data of D-FF 25 agree with each other. Thus, output data of D-FF 25, being same as the input data of D-FF 25, is latched into D-FF 30 if the output of AND gate 26 is logic value "1". This means that decoders are always controlled by control data signals which have been extracted at least twice but successively from the latest field of the TV format signal.

Therefore, in the above embodiment, the copy inhibition code, P correction discrimination code, Q correction discrimination code and pre-emphasis discrimination code each seriously affecting the decoding operation for the PCM audio signal, are sufficiently checked as regards their qualities.

## Claims

1. A PCM signal processor for decoding PCM signals from a TV format signal whose vertical period includes firstly a control data block (CDB) comprising a data word (CT) for use in the control of a decoding operation and an error detection and correction word (CRC) and secondly a data block (DB) comprising PCM data words, the said processor comprising means (12) for demodulating the said control data block and the said data block from the said TV format signal input to it, means (13) for converting the said blocks to parallel signals respectively, means (14) for de-interleaving the said parallel signals of the said data block, means (16 to 18) for processing the said de-interleaved signals, and means (15) connected to the said converting means and responsive to the said error detection and correction word for forming an error pointer signal having a first state indicating the presence of an error in the said control data block and a second state indicating the absence of an error in the said control data block, characterised in that the processor further comprises:

means (25) for latching the said control data word outputted (on 138) from the said converting means (13) when the said error pointer signal is in the said second state and for preventing the latching of the said control data word when the said error pointer signal is in the said first state;

means (29, 31) for checking agreement between the said control data word outputted from the said converting means and the said latched control data word in the said latching means; and

means (30) for applying the said latched control data word which is checked as regards agreement with the said outputted control data word to the said processing means so as to control the processing of the said de-interleaved PCM data words.

2. A PCM signal processor according to Claim 1, characterised in that the said latching means and the agreement checking means include first and second flip flops D-FF (25, 30) respectively, the D-FFs being connected in series between the said converting means (13) and the said processing means (16 to 18), the first D-FF (25) being nearer the converting means than the second D-FF (30), and the agreement checking means further includes an EX-NOR gate (29), having two inputs respectively connected to an input and an output of the first D-FF and an output connected to a set pulse input of the second D-FF.

3. A PCM signal processor according to Claim 1 or 2, further comprising an AND gate (26) which receives as one of its inputs the error pointer signal, which has been inverted, and as the other of its inputs a pulse indicative of the fact that the control data block is being applied to the processor, the output signal of the AND gate, when inverted, being such as to cause the means for latching the said control data word outputted from the said converting means to latch that control data word when the absence of an error in the control data block has been indicated.

## Patentansprüche

1. PCM-Signalprozessor zum Decodieren von PCM-Signalen aus einem Fernsehformat-Signal, dessen Vertikalperiode erstens einen Steuerdatenblock (CDB), der ein Steuerdatenwort (CT) zur Verwendung in der Steuerung eines Decodiervorgangs und ein Fehlererfassungs- und Korrekturwort (CRC) aufweist, und zweitens einen Datenblock (DB), der PCM-Datenwörter aufweist, enthält, wobei der Signalprozessor ein Mittel (12) zum Demodulieren des Steuerdatenblocks und des Datenblocks aus dem Fernsehformat-Eingangssignal für dieses, ein Mittel (13) zum Umsetzen der Blöcke jeweils in parallele Signale, ein Mittel (14) zum Entschachteln der parallelen Signale des Datenblocks, Mittel (16 bis 18) zum Verarbeiten der entschachtelten Signale und ein Mittel (15), das mit dem Mittel zum Umsetzen verbunden ist und auf das Fehlererfassungs- und Korrekturwort zum Bilden eines Fehleranzeigesignals anspricht, das einen ersten Signalzustand, der das Vorhandensein eines Fehlers in dem Steuerdatenblock anzeigt, und einen zweiten Signalzustand, der das Nichtvorhandensein eines Fehlers in dem Steuerdatenblock anzeigt, aufweist, dadurch gekennzeichnet, daß der Signalprozessor desweiteren folgende Elemente aufweist:

ein Mittel (25) zum Festhalten des Steuerdatenwortes, das auf einer Leitung (138) von dem Mittel (13) zum Umsetzen ausgegeben wird, wenn das Fehleranzeigesignal seinen zweiten Signalzustand aufweist, und zum Verhindern des Festhaltens des Steuerdatenwortes, wenn das Fehleranzeigesignal seinen ersten Signalzustand aufweist,

Mittel (29, 31) zum Prüfen der Übereinstimmung zwischen dem Steuerdatenwort, das von dem Mittel zum Umsetzen ausgegeben wird, und dem in dem Mittel zum Festhalten festgehaltenen Steuerdatenwort und

ein Mittel (30) zum Liefern des festgehaltenen Steuerdatenwortes, das hinsichtlich seiner Übereinstimmung mit dem ausgegebenen Steuerdatenwort geprüft ist, an die Mittel zum Verarbeiten, um so das Verarbeiten der entschachtelten PCM-Datenwörter zu steuern.

2. PCM-Signalprozessor nach Anspruch 1, dadurch gekennzeichnet, daß das Mittel zum Festhalten und die Mittel zum Prüfen der Übereinstimmung ein erstes bzw. ein zweites Flipflop, nämlich D-Flipflops (25, 30) enthalten, welche D-Flipflops in Reihe zwischen das Mittel (13) zum Umsetzen und die Mittel (16 bis 18) zum Verarbeiten geschaltet sind, wobei das erste D-Flipflop (25) näher an dem Mittel zum Umsetzen als das zweite D-Flipflop sitzt, und daß die Mittel zum Prüfen der Übereinstimmung desweiteren ein EX-NOR-Glied (29), das zwei Eingänge, die jeweils mit einem Eingang und einem Ausgang des ersten D-Flipflop verbunden sind, aufweist, und einen Ausgang, der mit einem Setzimpulseingang des zweiten D-Flipflop verbunden ist, enthalten.

3. PCM-Signalprozessor nach Anspruch 1 oder 2, dadurch gekennzeichnet, daß ein UND-Glied (26) vorgesehen ist, das als eines seiner Eingangssignale das Fehleranzeigesignal, welche invertiert worden ist, und als das andere seiner Eingangssignale einen Impuls, der die Tasache anzeigt, daß der Steuerdatenblock an den Signalprozessor geliefert wird, empfängt, wobei das Ausgangssignal des UND-Gliedes, wenn es invertiert wird, derart beschaffen ist, daß das Mittel zum Festhalten des Steuerdatenwortes, welches von dem Mittel zum Umsetzen ausgegeben wird, veranlaßt wird, dieses Steuerdatenwort festzuhalten, wenn das Nichtvorhandensein eines Fehlers in dem Steuerdatenblock angezeigt worden ist.

**Revendications**

1. Dispositif pour le traitement de signaux MIC permettant le décodage de signaux MIC à partir d'un signal de format TV dont la période verticale comprend premièrement un bloc de données de commande (CDB) comprenant un mot de données de commande (CT) destiné à être utilisé pour la commande d'une opération de décodage et un mot de détection et de correction d'erreurs (CRC) et deuxièmement un bloc de données (DB) comprenant des mots de données MIC, le dispositif comprenant des moyens (12) conçus pour la démodulation du bloc de données de commande et du bloc de données provenant du signal de format TV qui y est introduit en entrée, des moyens (13) conçus pour convertir ces blocs respectivement en signaux parallèles, des moyens (14) conçus pour la désimbrication des signaux parallèles du bloc de données, des moyens (16 à 18) conçus pour le traitement de ces signaux désimbriqués et des moyens (15) reliés aux moyens de conversion et intervenant en réponse au mot de détection et correction d'erreurs pour donner un signal détecteur d'erreurs comportant un premier état montrant la présence d'une erreur dans le bloc de données de commande et un deuxième état montrant l'absence d'erreur dans le bloc de données de commande, caractérisé en ce qu'il comprend, en plus, des moyens (25) assurant le verrouillage du mot de données de commande émis (sur 138) par les moyens de conversion (13) lorsque le signal indicateur d'erreurs est dans le deuxième état et empêchant le verrouillage du mot de données de commande lorsque le signal indicateur d'erreurs est dans le premier état, des moyens (29, 31) assurant le contrôle de l'accord entre le mot de données de commande provenant des moyens de conversion et le mot de données de commande verrouillé dans les moyens de verrouillage et des moyens (30) pour appliquer le mot de données de commande verrouillé, dont l'accord avec le mot de données de commande émis par les moyens de conversion a été contrôlé à l'organe de traitement afin de commander le traitement des mots de données MIC désimbriqués.

2. Dispositif pour le traitement de signaux MIC selon la revendication 1, caractérisé en ce que les moyens de verrouillage et les moyens de contrôle de l'accord comprennent respectivement une première et une deuxième bascule D-FF (25, 30), ces D-FF étant reliées en série entre les moyens de conversion (13) et les moyens de traitement (16 à 18), la première D-FF (25) étant plus proche des moyens de conversion que la deuxième D-FF (30) et les moyens de contrôle de l'accord comprenant, en plus, une porte EX-NI (29) qui comporte deux entrées reliées respectivement à une entrée et à une sortie de la première D-FF et une sortie reliée à une entrée d'impulsion de réglage de la deuxième D-FF.

3. Dispositif pour le traitement de signaux MIC selon l'une des revendications 1 ou 2, comprenant, en plus, une porte ET (26) qui reçoit, à l'une de ses entrées, le signal détecteur d'erreurs qui a été inversé, et, à son autre entrée, une impulsion indiquant que le bloc de données de commande se trouve appliqué au dispositif de traitement, le signal de sortie de la porte ET, lorsqu'il est inversé, étant tel que, sous son action, les moyens pouvant assurer le verrouillage du mot de données de commande en provenance des moyens de conversion verrouillent le mot de données de commande lors d'une information indiquant l'absence d'erreur dans le bloc de données de commande.

FIG. 1

FIG. 2

FIG. 3

FIG. 4A

FIG. 4B

0 0 4 8 1 5 2

FIG.5